(19) Europäisches Patentamt
European Patent Office
Office européen des brevets

(11) **EP 4 285 126 B1**

(12) **EUROPÄISCHE PATENTSCHRIFT**

(45) Veröffentlichungstag und Bekanntmachung des Hinweises auf die Patenterteilung:
**22.04.2026  Patentblatt 2026/17**

(21) Anmeldenummer: **22700620.2**

(22) Anmeldetag: **13.01.2022**

(51) Internationale Patentklassifikation (IPC):
**G01R 19/165** *(2006.01)*    **G01R 15/04** *(2006.01)*

(52) Gemeinsame Patentklassifikation (CPC):
**G01R 19/16547; G01R 15/04;** G01R 23/02

(86) Internationale Anmeldenummer:
**PCT/EP2022/050624**

(87) Internationale Veröffentlichungsnummer:
**WO 2022/161779 (04.08.2022 Gazette 2022/31)**

(54) **MESS-VORRICHTUNG ZUR DIFFERENTIELLEN SPANNUNGSMESSUNG**

MEASUREMENT DEVICE FOR DIFFERENTIAL VOLTAGE MEASUREMENT

DISPOSITIF DE MESURE POUR MESURE DE TENSION DIFFÉRENTIELLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **28.01.2021  DE 102021200762**

(43) Veröffentlichungstag der Anmeldung:
**06.12.2023  Patentblatt 2023/49**

(73) Patentinhaber: **BSH Hausgeräte GmbH**
**81739 München (DE)**

(72) Erfinder: **SCHMID, Florian**
**93173 Wenzenbach (DE)**

(56) Entgegenhaltungen:
WO-A1-2006/085771      CN-B- 105 870 931
DE-A1- 102017 205 359  JP-A- 2011 064 559
JP-A- 2012 002 542     JP-A- 2015 023 608
US-A1- 2003 168 995    US-A1- 2018 279 413

**Beschreibung**

Die Erfindung betrifft eine Vorrichtung, insbesondere eine Schaltanordnung, zur Messung einer Spannung, insbesondere einer Wechselspannung oder einer Gleichspannung (z.B. der Zwischenkreisspannung eines Schaltnetzteils oder einer Motorelektronik).

Ein Hausgerät, wie z.B. eine Waschmaschine oder eine Spülmaschine, weist typischerweise einen Netzanschluss, insbesondere ein Schaltnetzteil, auf, mit dem das Hausgerät an ein Wechselstrom-Versorgungsnetz angeschlossen werden kann. Die von einem Versorgungsnetz bereitgestellte Netz- bzw. Versorgungsspannung kann Schwankungen in Bezug auf die Spannungshöhe und/oder in Bezug auf die Frequenz aufweisen. Derartige Schwankungen können zu Überspannungssituationen und/oder zu Schwankungen der Leistungsaufnahme in einem Hausgerät und somit ggf. zu Beeinträchtigungen des Betriebs des Hausgeräts führen.

Messvorrichtungen zur Erfassung von Spannungen werden beispielsweise in der JP 2011 064559 A, WO 2006/085771 A1, US 2018/279413 A1, US 2003/168995 A1, JP 2015 023608 A , JP 2012 002542 A, CN 105 870 931 B oder der DE 10 2017 205359 A1.

Das vorliegende Dokument befasst sich mit der technischen Aufgabe, eine effiziente und präzise Messung der Netz- bzw. Versorgungsspannung eines elektrischen Geräts, insbesondere eines Hausgeräts, zu ermöglichen, um auch bei Schwankungen der Versorgungsspannung einen zuverlässigen und stabilen Betrieb des elektrischen Geräts zu ermöglichen.

Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt der Erfindung wird eine Hausgerät-Mess-Vorrichtung zur Ermittlung von Messinformation in Bezug auf eine Eingangsspannung gemäß Patentanspruch 1, insbesondere in Bezug auf eine Alternating Current (AC) - Eingangsspannung oder in Bezug auf eine Direct Current (DC) - Eingangsspannung, beschrieben. Die Mess-Vorrichtung kann insbesondere eingerichtet sein, ein oder mehrere Messspannungen für die Eingangsspannung bereitzustellen, die in zuverlässiger und effizienter Weise in einer Safety Extra Low Voltage (SELV) oder einer Protective Extra Low Voltage (PELV) Umgebung von einem Mikroprozessor eingelesen werden können. Die Eingangsspannung, insbesondere die AC-Eingangsspannung, kann z.B. eine 230Volt (V) Versorgungsspannung sein.

Die Mess-Vorrichtung umfasst einen ersten Eingangsknoten zur Kopplung mit einem ersten Pol (z.B. mit einem Phasenleiter oder mit dem Neutralleiter) der Eingangsspannung. Des Weiteren umfasst die Mess-Vorrichtung einen ersten Spannungsteiler, mit einem ersten Offset-Widerstand und einem ersten Mess-Widerstand, die zwischen einer Betriebs-Spannung (in diesem Dokument auch als "VDD" bezeichnet) und einem Referenzpotential (in diesem Dokument auch als "GND" bezeichnet) der Mess-Vorrichtung angeordnet sind. Zwischen dem ersten Offset-Widerstand und dem ersten Mess-Widerstand kann ein erster Messpunkt der Mess-Vorrichtung angeordnet sein. Der erste Mess-Widerstand kann zwischen dem ersten Messpunkt und dem Referenzpotential der Mess-Vorrichtung angeordnet sein, und der erste Offset-Widerstand kann zwischen dem ersten Messpunkt und der Betriebs-Spannung der Mess-Vorrichtung angeordnet sein.

Die Mess-Vorrichtung umfasst ferner einen ersten Isolationswiderstand, der den ersten Eingangsknoten mit dem ersten Messpunkt verbindet. An dem ersten Messpunkt kann Messinformation in Bezug auf die Eingangsspannung bereitgestellt werden. Insbesondere kann an dem ersten Messpunkt eine erste Messspannung (in Bezug auf die Eingangsspannung) bereitgestellt werden.

In entsprechender Weise umfasst die Mess-Vorrichtung einen zweiten Eingangsknoten zur Kopplung mit einem zweiten Pol (in komplementärer Weise zu dem ersten Pol z.B. mit dem Neutralleiter oder mit dem Phasenleiter) der Eingangsspannung. Des Weiteren umfasst die Mess-Vorrichtung einen zweiten Spannungsteiler, mit einem zweiten Offset-Widerstand und einem zweiten Mess-Widerstand, die zwischen der Betriebs-Spannung und dem Referenzpotential der Mess-Vorrichtung angeordnet sind. Zwischen dem zweiten Offset-Widerstand und dem zweiten Mess-Widerstand kann ein zweiter Messpunkt der Mess-Vorrichtung angeordnet sein. Der zweite Mess-Widerstand kann zwischen dem zweiten Messpunkt und dem Referenzpotential der Mess-Vorrichtung angeordnet sein, und der zweite Offset-Widerstand kann zwischen dem zweiten Messpunkt und der Betriebs-Spannung der Mess-Vorrichtung angeordnet sein.

Des Weiteren umfasst die Mess-Vorrichtung einen zweiten Isolationswiderstand, der den zweiten Eingangsknoten mit dem zweiten Messpunkt verbindet. An dem zweiten Messpunkt kann Messinformation in Bezug auf die Eingangsspannung bereitgestellt werden. Insbesondere kann an dem zweiten Messpunkt eine zweite Messspannung (in Bezug auf die Eingangsspannung) bereitgestellt werden.

Die Mess-Vorrichtung kann insbesondere eingerichtet sein, Messinformation in Bezug auf die Eingangsspannung auf Basis einer Differenz zwischen der ersten Messspannung und der zweiten Messspannung bereitzustellen. So kann in effizienter und zuverlässiger Weise (insbesondere über eine Isolationsbarriere hinweg) eine Messung der Eingangsspannung ermöglicht werden.

Die Eingangsspannung kann Teil eines ersten Spannungsbezugsystems sein. Die Eingangsspannung kann z.B.

eine Amplitude von 100V oder mehr aufweisen. Das erste Spannungsbezugssystem kann z.B. eine Versorgungsspannung (z.B. eine 230V Versorgungsspannung) oder eine Zwischenkreisspannung (etwa eines Schaltnetzteils oder einer Elektronik für einen BLDC Motor, d.h. für einen bürstenlosen Gleichstrommotor) sein. Andererseits können die Betriebs-Spannung und/oder das Referenzpotential Teil eines zweiten Spannungsbezugsystems, insbesondere eines SELV oder eines PELV Spannungsbezugsystems, sein. Die erste und/oder die zweite Messspannung können z.B. jeweils eine Amplitude von 50V oder weniger aufweisen. Zwischen den beiden Spannungsbezugssystemen kann eine Isolationsbarriere angeordnet sein, die insbesondere durch die Isolationswiderstände der Mess-Vorrichtung bereitgestellt wird. Es kann somit in effizienter und zuverlässiger Weise eine Messung der Eingangsspannung aus einem anderen Spannungsbezugsbereich heraus ermöglicht werden.

Der erste Isolationswiderstand und der zweite Isolationswiderstand können erfindungsgemäß jeweils einen derart hohen Widerstandswert aufweisen, dass durch den ersten Isolationswiderstand und durch den zweiten Isolationswiderstand eine galvanische Isolation mit einem Leckstrom bewirkt wird, der kleiner als ein (innerhalb einer Vorschrift) vordefinierter Leckstrom-Schwellenwert ist. Gemäß der vorliegenden Erfindung weist der erste Isolationswiderstand einen Widerstandswert auf, der um einen Faktor 10 oder mehr, oder 100 oder mehr oder 1000 oder mehr oder 10000 oder mehr höher als der Widerstandswert des ersten Offset-Widerstands und/oder des ersten Mess-Widerstands ist. In entsprechender Weise kann der zweite Isolationswiderstand einen Widerstandswert aufweisen, der um einen Faktor 10 oder mehr, oder 100 oder mehr oder 1000 oder mehr oder 10000 oder mehr höher als der Widerstandswert des zweiten Offset-Widerstands und/oder des zweiten Mess-Widerstands ist. So kann in besonders effizienter Weise eine Isolationsbarriere zwischen dem ersten Spannungsbezugsbereich und dem zweiten Spannungsbezugsbereich bereitgestellt werden.

Die Mess-Vorrichtung kann ausgebildet sein, auf Basis der ersten Messspannung an dem ersten Messpunkt, insbesondere auf Basis der ersten Messspannung zwischen dem ersten Messpunkt und dem Referenzpotential, und auf Basis der zweiten Messspannung an dem zweiten Messpunkt, insbesondere auf Basis der zweiten Messspannung zwischen dem zweiten Messpunkt und dem Referenzpotential, Messinformation in Bezug auf die Eingangsspannung zu ermitteln. Die Messinformation kann insbesondere auf Basis der Differenz zwischen der ersten und der zweiten Messspannung ermittelt werden. Die Messinformation kann die Amplitude der Eingangsspannung, die Polarität der Eingangsspannung, die Frequenz der Eingangsspannung und/oder den Zeitpunkt zumindest eines Nulldurchgangs der Eingangsspannung umfassen. Aufgrund der Verwendung von mehreren Messspannungen, insbesondere aufgrund der Differenzbildung zwischen mehreren Messspannungen, kann die Messinformation in besonders präziser und robuster Weise bereitgestellt werden.

Die Mess-Vorrichtung kann ausgebildet sein, an dem ersten Mess-Widerstand und/oder an dem ersten Messpunkt eine erste Messspannung für die Eingangsspannung bereitzustellen, die keine Polaritätswechsel aufweist. Dies kann insbesondere durch Verwendung des ersten Spannungsteilers zwischen der Betriebs-Spannung und dem Referenzpotential der Mess-Vorrichtung erreicht werden. In entsprechender Weise kann die Mess-Vorrichtung ausgebildet sein, an dem zweiten Mess-Widerstand und/oder an dem zweiten Messpunkt eine zweite Messspannung für die Eingangsspannung bereitzustellen, die keine Polaritätswechsel aufweist. Dies kann insbesondere durch Verwendung des zweiten Spannungsteilers zwischen der Betriebs-Spannung und dem Referenzpotential der Mess-Vorrichtung erreicht werden. Durch die Bereitstellung von Messspannungen, die keine Polaritätswechsel aufweisen, die aber dennoch Information in Bezug auf eine Eingangsspannung anzeigen, kann eine besonders effiziente Weiterverarbeitung der Messspannungen (durch unipolare Analog-Digital-Wandler) ermöglicht werden.

Die Mess-Vorrichtung kann einen ersten Kondensator umfassen, der parallel zu dem ersten Mess-Widerstand, insbesondere zwischen dem ersten Messpunkt und dem Referenzpotential, angeordnet ist. In entsprechender Weise kann die Mess-Vorrichtung einen zweiten Kondensator umfassen, der parallel zu dem zweiten Mess-Widerstand, insbesondere zwischen dem zweiten Messpunkt und dem Referenzpotential, angeordnet ist. Durch die Kondensatoren kann eine Tiefpassfilterung zur Reduzierung von Rauschen und/oder von Aliasing, bei Abtastung durch einen Analog-Digital-Wandler, bereitgestellt werden.

Die Mess-Vorrichtung kann einen Komparator umfassen, wobei der erste Eingang des Komparators mit dem ersten Messpunkt und der zweite Eingang des Komparators mit dem zweiten Messpunkt gekoppelt sein können. Der Komparator kann ausgebildet sein, als Ausgangssignal einen Polaritätswechsel und/oder einen Nulldurchgang der Eingangsspannung anzuzeigen. Des Weiteren kann die Mess-Vorrichtung einen (Mikro-) Prozessor umfassen, der eingerichtet ist, auf Basis des Ausgangssignals des Komparators die Frequenz der Eingangsspannung zu ermitteln. Durch die Bereitstellung eines Komparators kann in effizienter und präziser Weise Messinformation in Bezug auf die Eingangsspannung, insbesondere in Bezug auf ein oder mehrere Nulldurchgänge der Eingangsspannung, ermittelt werden.

Die Mess-Vorrichtung kann einen ersten Analog-Digital-Wandler umfassen, der eingerichtet ist, die erste Messspannung an dem ersten Messpunkt in eine erste digitale Messspannung zu wandeln. In entsprechender Weise kann die Mess-Vorrichtung einen zweiten Analog-Digital-Wandler umfassen, der eingerichtet ist, die zweite Messspannung an dem zweiten Messpunkt in eine zweite digitale Messspannung zu wandeln. Die Mess-Vorrichtung kann ferner einen (Mikro-) Prozessor umfassen, der eingerichtet ist, auf Basis der ersten digitalen Messspannung und auf Basis der zweiten digitalen Messspannung als Messinformation einen Messwert für die Eingangsspannung, insbesondere einen Messwert für die Amplitude der Eingangsspannung, zu ermitteln. Dabei kann wiederholt der jeweils aktuelle Messwert ermittelt werden, z.B. um die Signalform der Eingangsspannung und/oder den zeitlichen Verlauf der Amplitude der Eingangsspannung zu ermitteln.

Dabei kann der Prozessor ausgebildet sein, den Messwert für die Eingangsspannung näherungsweise auf Basis der folgenden Formel zu berechnen,

$$U1\_U2 = \left(U\_M1\_GND * \frac{R\_1 * R\_M1 + R\_1 * R\_OS1 + R\_M1 * R\_OS1}{R\_M1 * R\_OS1} - VDD \right.$$
$$\left. * \frac{R\_1}{R\_OS1}\right)$$
$$- \left(U\_M2\_GND * \frac{R\_2 * R\_M2 + R\_2 * R\_OS2 + R\_M2 * R\_OS2}{R\_M2 * R\_OS2} - VDD \right.$$
$$\left. * \frac{R\_2}{R\_OS2}\right)$$

In der o.g. Formel sind: U1_U2 der Messwert der Eingangsspannung; U_M1_GND der Wert der ersten digitalen Messspannung; R_1 der Wert des ersten Isolationswiderstands; R_M1 der Wert des ersten Mess-Widerstands; R_OS1 der Wert des ersten Offset-Widerstands; VDD der Wert der Betriebs-Spannung relativ zu dem Referenzpotential; U_M2_GND der Wert der zweiten digitalen Messspannung; R_2 der Wert des zweiten Isolationswiderstands; R_M2 der Wert des zweiten Mess-Widerstands; und R_OS2 der Wert des zweiten Offset-Widerstands.

Der Messwert der Eingangsspannung kann somit in besonders präziser Weise ermittelt werden.

Gemäß einem weiteren Aspekt wird ein Hausgerät (z.B. eine Waschmaschine, eine Spülmaschine, ein Ofen, ein Herd, eine Küchenmaschine, ein Staubsauger, ein Trockner, ein Kühlschrank, etc.) beschrieben, das die in diesem Dokument beschriebene Mess-Vorrichtung umfasst. Das Hausgerät kann insbesondere einen Netzanschluss zur Anbindung des Hausgeräts an eine AC-Versorgungsspannung umfassen. Die Mess-Vorrichtung kann eingerichtet sein, auf Basis der AC-Versorgungsspannung Messinformation in Bezug auf die Versorgungsspannung zu ermitteln.

Das Hausgerät kann ferner eine Steuereinheit umfassen, die eingerichtet ist, eine Funktion des Hausgeräts in Abhängigkeit von der Messinformation, insbesondere in Abhängigkeit von einem Messwert der Amplitude der Versorgungsspannung, zu betreiben. Beispielsweise kann eine Leistungssteuerung bzw. -regelung des Hausgeräts in Abhängigkeit von der Messinformation erfolgen. So kann ein besonders sicherer und zuverlässiger Betrieb des Hausgeräts ermöglicht werden.

Es ist zu beachten, dass jegliche Aspekte der in diesem Dokument beschriebenen Mess-Vorrichtung in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen

Figur 1     ein Blockdiagramm eines beispielhaften Hausgeräts;
Figur 2a     ein Blockdiagramm einer beispielhaften Mess-Vorrichtung zur Spannungsmessung; und
Figur 2b     eine beispielhafte Mess-Vorrichtung mit einem Komparator.

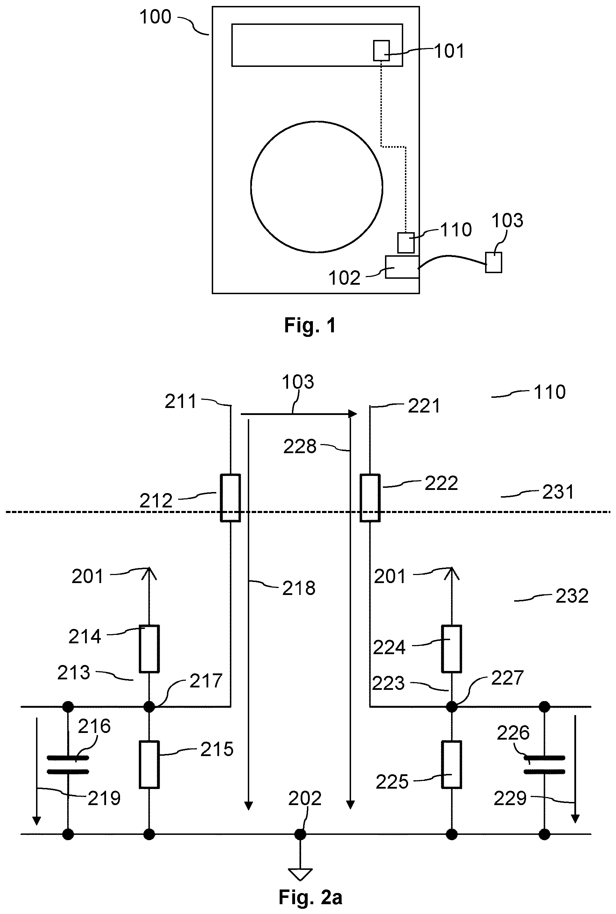

Wie eingangs dargelegt, befasst sich das vorliegende Dokument damit, auch bei Schwankungen der Versorgungsspannung in effizienter Weise einen stabilen und zuverlässigen Betrieb eines Hausgeräts zu ermöglichen. In diesem Zusammenhang zeigt Fig. 1 ein beispielhaftes Hausgerät 100, z.B. eine Waschmaschine, mit einem Netzanschluss 102, insbesondere mit einem Schaltnetzteil, über das das Hausgerät 100 an eine Wechselstrom-Versorgungsspannung 103 angeschlossen werden kann. Das Hausgerät 100 umfasst eine Mess-Vorrichtung 110, die eingerichtet ist, ein oder mehrere Messsignale in Bezug auf die Versorgungsspannung 103 zu erfassen. Das eine oder die mehreren Messsignale (z.B. eine erste Messspannung, eine zweite Messspannung und/oder das Ausgangssignal eines Komparators) können durch eine Steuereinheit 101, z.B. durch einen Mikroprozessor, des Hausgeräts 100 ausgewertet werden, insbesondere um den Betrieb des Hausgeräts 100 an eine jeweils aktuelle Eigenschaft, z.B. Amplitude und/oder Frequenz, der Versorgungs- bzw. Netzspannung 103 anzupassen. So kann auch bei Schwankungen der Versorgungsspannung 103 ein stabiler und zuverlässiger Betrieb des Hausgeräts 100 ermöglicht werden.

Fig. 1 zeigt somit ein Hausgerät 100, das über einen Netzstecker mit dem öffentlichen Stromnetz verbunden und so mit elektrischer Energie versorgt werden kann. Das öffentliche Stromnetz kann als "Spannungsbezugssystem A" betrachtet werden. Spannungsführende Teile in und an dem Hausgerät 100, welche eine Verbindung zu diesem Spannungsbezugssystem haben, müssen typischerweise elektrisch isoliert und vor Berührung durch einen Benutzer des Hausgeräts 100 geschützt werden. So können in zuverlässiger Weise Stromschläge, bedingt durch die relativ hohe Spannung dieses Spannungsbezugssystems, vermieden werden. Eine derartige Isolation ist in einem Hausgerät 100 beispielsweise im Bereich der Benutzerschnittstelle oder bei Anbaugeräten wie beispielsweise einem Bratenthermometer ggf. nicht möglich oder mit einem relativ hohen Aufwand verbunden.

Aus diesem Grund weist ein Hausgerät 100 typischerweise ein eigenes Stromnetz auf, das als "Spannungsbezugssystem B" bezeichnet werden kann und das eine gegenüber der Netzspannung 103 reduzierte (Betriebs-) Spannung (in diesem Dokument auch als VDD bezeichnet) aufweist, durch die Stromschläge für einen Benutzer zuverlässig vermieden werden können. Nicht isolierfähige Komponenten des Hausgeräts 100 können innerhalb des Spannungsbezugssystems B sicher mit elektrischer Energie versorgt werden.

Ein Pol des öffentlichen Stromnetzes ist typischerweise mit Erde verbunden, was es erforderlich macht, das Spannungsbezugssystem A und das Spannungsbezugssystem B galvanisch voneinander zu isolieren. Die galvanische Trennung kann durch eine sogenannte Isolationsbarriere bewirkt werden. Die Energieübertragung zwischen beiden Spannungsbezugssystemen kann magnetisch mithilfe eines Transformators (als Teil der Isolationsbarriere) erfolgen.

Eine Isolationsbarriere weist meist einen maximal zulässigen Ableitstrom (der auch als Leckstrom bezeichnet wird) und/oder ein oder mehrere weitere Isolationseigenschaften, wie z.B. einen bestimmten geometrischen Abstand und/oder eine bestimmte Spannungsfestigkeit, auf. Durch eine Isolationsbarriere geht meist der elektrisch definierte Bezug der beiden Spannungsbezugssysteme zueinander, die von der Isolationsbarriere galvanisch voneinander getrennt werden, verloren. Wenn die Spannung des Spannungsbezugssystems A innerhalb des Spannungsbezugssystems B gemessen werden soll, ist es daher typischerweise erforderlich, dem Spannungsbezugssystem B diese relative Spannungsinformation zu übermitteln, ohne dabei die Isolationsbarriere außer Kraft zu setzen.

Ein Beispiel für eine Spannungsmessung über eine Isolationsbarriere hinweg in einem Hausgerät 100 ist die Messung der Netzspannung 103. Gemessene Information in Bezug auf die Netzspannung 103 kann z.B. dafür verwendet werden, eine Schutzfunktion in dem Hausgerät 100 zu aktivieren oder ein oder mehrere Prozesse, wie beispielsweise das Abtauen eines Kühlgeräts mithilfe von Heizungen, energetisch zu optimieren.

In diesem Dokument wird eine Mess-Vorrichtung 110 zur Messung einer elektrischen Spannung 103 über eine Isolationsbarriere hinweg beschrieben, die einen für die Isolationsbarriere vorgesehenen maximal zulässigen Leckstrom und/oder ein oder mehrere weitere Isolationseigenschaften bzw. Isolationsanforderungen erfüllt.

Fig. 2a zeigt ein Schaltdiagramm einer beispielhaften Mess-Vorrichtung 110. Die Mess-Vorrichtung 110 ist eingerichtet, die Potenzialdifferenz 103 "U1_U2" zwischen den Punkten 211 "U1" und 221 "U2" (d.h. die Eingangsspannung 103) eindeutig durch die Differenz der Messspannungen 219 "U_M1_GND" (zwischen dem ersten Messpunkt 217 "U_M1" und dem Referenzpotential 202 "GND") und 229 "U_M2_GND" (zwischen dem zweiten Messpunkt 227 "U_M2" und dem Referenzpotential 202 "GND") zu bestimmen.

Die Offset-Widerstände 214 "R_OS1" und 224 "R_OS2" stellen eine Verbindung der Messpunkte 217 "U_M1" und 227 "U_M2" zu der Betriebs-Spannung 201 "VDD" des zweiten Spannungsbezugsystems B 232 her. Die Betriebs-Spannung 201 "VDD" kann bezogen auf das Referenzpotential 202 "GND" einen festen Wert aufweisen. So kann den Messspannungen 219 "U_M1_GND" und 229 "U_M2_GND" jeweils eine Offsetspannung hinzugefügt werden, welche es ermöglicht, die Messspannungen 219, 229 jeweils ausschließlich im positiven Bereich zu halten. Dies ist vorteilhaft, um die einzelnen Messspannungen 219, 229 jeweils über einen unipolaren Analog-Digital-Wandler in einem Mikroprozessor aufzunehmen.

Die Widerstände 212 "R_1", 214 "R_OS1" und 215 "R_M1" sowie die Widerstände 222 "R_2", 224 "R_OS2" und 225 "R_M2" bilden jeweils einen Spannungsteiler 213, 223 zwischen der Spannung 218 "U1_GND" und der ersten Messspannung 219 "U_M1_GND" bzw. zwischen der Spannung 228 "U2_GND" und der zweiten Messspannung 229 "U_M2_GND".

Die Potenzialdifferenz zwischen den Eingangsknoten 211 "U1" und 221 "U2" stellt die Eingangsspannung 103 "U1_U2" dar. Dabei sind die Potenzialdifferenzen oder Spannungen 218 "U1_GND" sowie 228 "U2_GND" absolut gesehen typischerweise nicht von Bedeutung. Störungen, Gleichtaktspannungen oder zusätzliche Impedanzen zwischen den Eingangsknoten 211 "U1" und 221 "U2" und dem Referenzpotential 202 "GND" löschen sich durch die Differenzbildung aus und es bleibt nur die Eingangsspannung 103 "U1_U2" als Ergebnis bestehen. So ist es möglich, in einem System, bei dem ein Punkt 202 als Potenzialbezugspunkt ("GND") festgelegt ist, eine Spannung zwischen zwei Eingangsknoten 211, 221 ("U1" und "U2") zu messen, unabhängig von den jeweiligen absoluten Potenzialdifferenzen 218, 228 der einzelnen Eingangsknoten 211, 221 zu dem Potenzialbezugspunkt 202 ("GND") des Systems. So wird eine hochohmige Anbindung beider Eingangsknoten 211, 221 ("U1" und "U2") an die Mess-Vorrichtung 110 ermöglicht.

Die Kondensatoren 216 "C_F1" und 226 "C_F2" können zur Tiefpassfilterung der Messspannung verwendet werden. Wenn keine Tiefpassfilterung benötigt wird, können die Kondensatoren 216, 226 entfallen.

Durch die Verwendung von relativ hohen Widerstandswerten der Isolationswiderstände 212 "R_1" und 222 "R_2" und durch eine entsprechende Begrenzung der elektrischen Ströme über die Isolationswiderstände 212, 222, wird eine Spannungsmessung über eine Isolationsbarriere zwischen dem ersten Spannungsbezugssystem A 231 und dem zweiten Spannungsbezugssystem B 232 hinweg ermöglicht.

Je höher der Widerstandswert der Isolationswiderstände 212 "R_1" und 222 "R_2" gewählt wird, desto größer ist typischerweise der Störeinfluss von parasitären Kapazitäten auf die absoluten Spannungen 218 "U1_GND" und 228 "U2_GND". Durch die differenzielle Spannungsmessung löschen sich diese Störeinflüsse jedoch im Rahmen der Differenzbildung komplett aus, sodass auch bei Reduzierung der Leckströme der Isolationsbarriere durch Erhöhung des Widerstandswertes der Isolationswiderstände 212 "R_1" und 222 "R_2" eine präzise Messung der Eingangsspannung 103 über die Differenz der Messspannungen 219, 229 ermöglicht wird. Dabei verwendet die in Fig. 2a dargestellte Mess-Vorrichtung 110 ausschließlich passive Bauteile und ermöglicht somit eine besonders effiziente Implementierung.

Der Zusammenhang zwischen der ersten Messspannung 219 "U_M1_GND" und der zweiten Messspannung 229 "U_M2_GND" (im zweiten Spannungsbezugssystem B 232) einerseits und der zu messenden Eingangsspannung 103 "U1_U2" (im ersten Spannungsbezugssystem A 231) andererseits kann durch folgende Formel näherungsweise beschrieben werden:

$$U1\_U2 = \left( U\_M1\_GND * \frac{R\_1 * R\_M1 + R\_1 * R\_OS1 + R\_M1 * R\_OS1}{R\_M1 * R\_OS1} - VDD \right. \\ \left. * \frac{R\_1}{R\_OS1} \right) \\ - \left( U\_M2\_GND * \frac{R\_2 * R\_M2 + R\_2 * R\_OS2 + R\_M2 * R\_OS2}{R\_M2 * R\_OS2} - VDD \right. \\ \left. * \frac{R\_2}{R\_OS2} \right)$$

Eine Frequenzabhängigkeit durch den Einfluss der Kondensatoren 216 "C_F1" und 226 "C_F2" wird dabei aus Gründen der Übersichtlichkeit vernachlässigt.

Die in Fig. 2a dargestellte Mess-Vorrichtung 110 kann zur Messung der Netzspannung 103 in einem Hausgerät 100 verwendet werden. Zu diesem Zweck kann der erste Eingangsknoten 211 "U1" mit dem Außenleiter bzw. Phasenleiter und der zweite Eingangsknoten 221 "U2" mit dem Neutralleiter des Stromnetzes verbunden werden. Alternativ können der erste Eingangsknoten 211 "U1" mit dem Neutralleiter und der zweite Eingangsknoten 221 "U2" mit dem Außenleiter bzw. Phasenleiter des Stromnetzes verbunden werden. Die Messspannungen 219 "U_M1_GND" sowie 229 "U_M2_GND" können jeweils von einem Analog-Digital-Wandler (nicht dargestellt) gemessen werden, wobei sich die Analog-Digital-Wandler in dem vom Stromnetz galvanisch isolierten zweiten Spannungsbezugssystem B 232 befinden. Die Auswertung der gewandelten und/oder digitalen Messspannungen 219, 229 kann durch einen Mikrocontroller (nicht dargestellt) erfolgen, der ausgebildet ist, die Netzspannung 103 z.B. anhand der o.g. Formel aus den Messspannungen 219, 229 zu berechnen.

Die einzige Verbindung der Mess-Vorrichtung 110 zum Stromnetz über die Isolationsbarriere hinweg stellen die Isolationswiderstände 212 "R_1" und 222 "R_2" dar. Werden die Widerstandswerte für die Isolationswiderstände 212 "R_1" und 222 "R_2" ausreichend hoch gewählt, wird der Strom durch die Isolationswiderstände 212, 222 und somit der Strom über die Isolationsbarriere hinweg ausreichend geringgehalten. Es kann somit eine intakte Isolationsbarriere bereitgestellt werden.

Die in diesem Dokument beschriebene Mess-Vorrichtung 110 ermöglicht es, jede beliebige Eingangsspannung 103 in einem ersten Spannungsbezugssystem A 231 zu messen, ohne den Potenzialbezugspunkt des ersten Spannungsbezugssystems A 231 niederohmig mit dem Potenzialbezugspunkt 202 des zweiten Spannungsbezugssystems B 232, von dem aus die Eingangsspannung 103 in dem ersten Spannungsbezugssystem A 231 gemessen werden soll, zu verbinden.

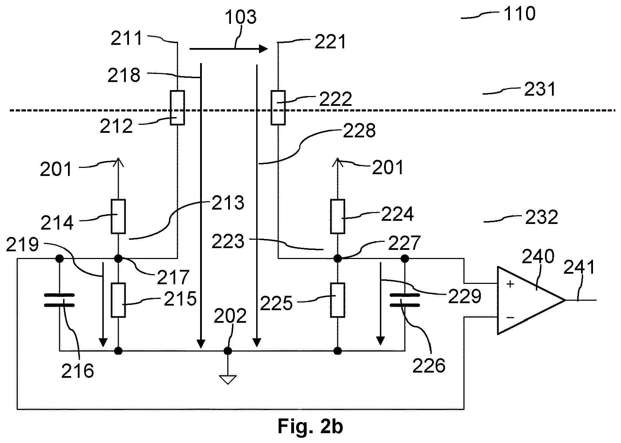

Die Mess-Vorrichtung 110 kann, wie beispielhaft in Fig. 2b dargestellt, zur Erkennung des Nulldurchgangs der Netzspannung 103 verwendet werden. Die Erkennung des Nulldurchgangs kann beispielsweise für das netzspannungssynchrone Schalten eines Aktors eines Hausgeräts 100 verwendet werden. Ferner kann anhand der Mess-Vorrichtung 110 (durch eine Nulldurchgangserkennung) die Messung der Netzfrequenz (z.B. als Taktgeber für ein oder mehrere Prozesse eines Hausgeräts 100) erfolgen.

Die Eingangsknoten 211 "U1" und 221 "U2" werden, wie weiter oben dargelegt, mit dem Stromnetz verbunden. Im Moment eines Nulldurchgangs der Netzspannung 103 wechseln die Spannung zwischen den Eingangsknoten 211 "U1" und 221 "U2" und somit auch die Differenz zwischen den Messspannungen 219 "U_M1_GND" und 229 "U_M2_GND" das Vorzeichen. Dieser Vorzeichenwechsel kann mithilfe eines Komparators 240, verbunden mit den Messpunkten 217 "U_M1" und 227 "U_M2", ausgewertet werden. Jede fallende oder steigende Signalflanke am Komparator-Ausgang 241 zeigt dann einen Nulldurchgang der Netzspannung 103 an. Der jeweilige Signalzustand des Komparator-Ausgangs 241 (High oder Low) zeigt zudem die jeweils aktuelle Polarität der Netzspannung 103 an.

Die in diesem Dokument beschriebene Mess-Vorrichtung 110 kann in effizienter Weise mit einem geringen Bauteilaufwand (insbesondere mit nur sechs Widerständen) implementiert werden. Dabei können die Isolationswiderstände 212 "R_1" und 222 "R_2" ggf. jeweils durch eine Kombination von mehreren Widerständen realisiert werden. Ferner ermöglicht die Mess-Vorrichtung 110 eine Netzspannungsmessung und/oder eine Nulldurchgangserkennung in Geräten 100, in denen keine netzpotentialbezogene Messschaltung vorgesehen oder implementierbar ist. Da die Mess-Vorrichtung 110 nur passive Bauteile aufweist, sind Störeinflüsse durch Bauteiltoleranzen in effizienter und präziser Weise zu berechnen und bei der Ermittlung von Messinformation in Bezug auf die Eingangsspannung 103 zu berücksichtigen. Ferner wird eine effiziente und präzise Kalibrierung der Mess-Vorrichtung 110 ermöglicht, da die Bauteile der Mess-Vorrichtung 110 in erster Näherung ein lineares Verhalten aufweisen.

Die vorliegende Erfindung ist nicht auf die gezeigten Ausführungsbeispiele beschränkt. Insbesondere ist zu beachten, dass die Beschreibung und die Figuren nur das Prinzip der vorgeschlagenen Mess-Vorrichtung veranschaulichen sollen.

## Patentansprüche

1. Hausgerät-Mess-Vorrichtung (110) zur Ermittlung von Messinformation in Bezug auf eine Eingangsspannung (103) über eine Isolationsbarriere hinweg; wobei die Hausgerät-Mess-Vorrichtung (110) umfasst,

   - einen ersten Eingangsknoten (211) zur Kopplung mit einem ersten Pol der Eingangsspannung (103);
   - einen ersten Spannungsteiler (213), mit einem ersten Offset-Widerstand (214) und einem ersten Mess-Widerstand (215), die zwischen einer Betriebs-Spannung (201) und einem Referenzpotential (202) der Hausgerät-Mess-Vorrichtung (110) angeordnet sind;
   - einen ersten Isolationswiderstand (212), der den ersten Eingangsknoten (211) mit einem, zwischen dem ersten Offset-Widerstand (214) und dem ersten Mess-Widerstand (215) angeordneten, ersten Messpunkt (217) für Messinformation in Bezug auf die Eingangsspannung (103) verbindet;
   - einen zweiten Eingangsknoten (221) zur Kopplung mit einem zweiten Pol der Eingangsspannung (103);
   - einen zweiten Spannungsteiler (223), mit einem zweiten Offset-Widerstand (224) und einem zweiten Mess-Widerstand (225), die zwischen der Betriebs-Spannung (201) und dem Referenzpotential (202) der Hausgerät-Mess-Vorrichtung (110) angeordnet sind; und
   - einen zweiten Isolationswiderstand (222), der den zweiten Eingangsknoten (221) mit einem, zwischen dem zweiten Offset-Widerstand (224) und dem zweiten Mess-Widerstand (225) angeordneten, zweiten Messpunkt (227) für Messinformation in Bezug auf die Eingangsspannung (103) verbindet,
   - wobei der erste Isolationswiderstand (212) einen Widerstandswert aufweist, der um einen Faktor 10 oder mehr, oder 100 oder mehr oder 1000 oder mehr oder 10000 oder mehr höher als ein Widerstandswert des ersten Offset-Widerstands (214) und/oder des ersten Mess-Widerstands (215) ist; und/oder
   - der zweite Isolationswiderstand (222) einen Widerstandswert aufweist, der um einen Faktor 10 oder mehr, oder 100 oder mehr oder 1000 oder mehr oder 10000 oder mehr höher als ein Widerstandswert des zweiten Offset-Widerstands (224) und/oder des zweiten Mess-Widerstands (225) ist.

2. Hausgerät-Mess-Vorrichtung (110) gemäß Anspruch 1, wobei der erste Isolationswiderstand (212) und der zweite Isolationswiderstand (222) jeweils einen derart hohen Widerstandswert aufweisen, dass durch den ersten Isolationswiderstand (212) und durch den zweiten Isolationswiderstand (222) eine galvanische Isolation mit einem Leckstrom bewirkt wird, der kleiner als ein vordefinierter Leckstrom-Schwellenwert ist.

3. Hausgerät-Mess-Vorrichtung (110) gemäß einem der vorhergehenden Ansprüche, wobei

   - die Eingangsspannung (103) Teil eines ersten Spannungsbezugsystems (231), insbesondere eines Elektrizitätsversorgungsnetzes oder eines Zwischenkreises eines elektrischen Geräts (100), ist; und/oder
   - die Betriebs-Spannung (201) und/oder das Referenzpotential (202) Teil eines zweiten Spannungsbezugsystems (232), insbesondere eines Safety Extra Low Voltage, kurz SELV, oder eines Protective Extra Low Voltage, kurz PELV, Spannungsbezugsystems, sind.

4. Hausgerät-Mess-Vorrichtung (110) gemäß einem der vorhergehenden Ansprüche, wobei die Hausgerät-Mess-Vorrichtung (110) ausgebildet ist, auf Basis einer ersten Messspannung (219) an dem ersten Messpunkt (217), insbesondere einer ersten Messspannung (219) zwischen dem ersten Messpunkt (217) und dem Referenzpotential (202), und auf Basis einer zweiten Messspannung (229) an dem zweiten Messpunkt (227), insbesondere einer zweiten Messspannung (229) zwischen dem zweiten Messpunkt (227) und dem Referenzpotential (202), Messinformation in Bezug auf die Eingangsspannung (103) zu ermitteln.

5. Hausgerät-Mess-Vorrichtung (110) gemäß einem der vorhergehenden Ansprüche, wobei

- der erste Mess-Widerstand (215) zwischen dem ersten Messpunkt (217) und dem Referenzpotential (202) der Hausgerät-Mess-Vorrichtung (110) angeordnet ist; und
- der erste Offset-Widerstand (214) zwischen dem ersten Messpunkt (217) und der Betriebs-Spannung (201) der Hausgerät-Mess-Vorrichtung (110) angeordnet ist; und/oder
- der zweite Mess-Widerstand (225) zwischen dem zweiten Messpunkt (227) und dem Referenzpotential (202) der Hausgerät-Mess-Vorrichtung (110) angeordnet ist; und
- der zweite Offset-Widerstand (224) zwischen dem zweiten Messpunkt (227) und der Betriebs-Spannung (201) der Hausgerät-Mess-Vorrichtung (110) angeordnet ist.

6. Hausgerät-Mess-Vorrichtung (110) gemäß einem der vorhergehenden Ansprüche, wobei die Hausgerät-Mess-Vorrichtung (110) ausgebildet ist,

- an dem ersten Mess-Widerstand (215) und/oder an dem ersten Messpunkt (217) eine erste Messspannung (219) für die Eingangsspannung (103) bereitzustellen, die keine Polaritätswechsel aufweist; und/oder
- an dem zweiten Mess-Widerstand (225) und/oder an dem zweiten Messpunkt (227) eine zweite Messspannung (229) für die Eingangsspannung (103) bereitzustellen, die keine Polaritätswechsel aufweist.

7. Hausgerät-Mess-Vorrichtung (110) gemäß Anspruch 6, wobei

- die Eingangsspannung (103) eine Amplitude von 100V oder mehr aufweist; und
- die erste und/oder die zweite Messspannung (219, 229) jeweils eine Amplitude von 50V oder weniger aufweisen.

8. Hausgerät-Mess-Vorrichtung (110) gemäß einem der vorhergehenden Ansprüche, wobei die Hausgerät-Mess-Vorrichtung (110) umfasst,

- einen ersten Kondensator (216), der parallel zu dem ersten Mess-Widerstand (215), insbesondere zwischen dem ersten Messpunkt (217) und dem Referenzpotential (202), angeordnet ist; und/oder
- einen zweiten Kondensator (226), der parallel zu dem zweiten Mess-Widerstand (225), insbesondere zwischen dem zweiten Messpunkt (227) und dem Referenzpotential (202), angeordnet ist.

9. Hausgerät-Mess-Vorrichtung (110) gemäß einem der vorhergehenden Ansprüche, wobei

- die Hausgerät-Mess-Vorrichtung (110) einen Komparator (240) umfasst;
- ein erster Eingang des Komparators (240) mit dem ersten Messpunkt (217) gekoppelt ist;
- ein zweiter Eingang des Komparators (240) mit dem zweiten Messpunkt (227) gekoppelt ist; und
- der Komparator (240) ausgebildet ist, als Ausgangssignal (241) einen Polaritätswechsel und/oder einen Nulldurchgang der Eingangsspannung (103) anzuzeigen.

10. Hausgerät-Mess-Vorrichtung (110) gemäß Anspruch 10, wobei die Hausgerät-Mess-Vorrichtung (110) einen Prozessor umfasst, der eingerichtet ist, auf Basis des Ausgangssignals (241) des Komparators (240) eine Frequenz der Eingangsspannung (103) zu ermitteln.

11. Hausgerät-Mess-Vorrichtung (110) gemäß einem der vorhergehenden Ansprüche, wobei die Hausgerät-Mess-Vorrichtung (110) umfasst,

- einen ersten Analog-Digital-Wandler, der eingerichtet ist, eine erste Messspannung (219) an dem ersten Messpunkt (217) in eine erste digitale Messspannung zu wandeln; und/oder
- einen zweiten Analog-Digital-Wandler, der eingerichtet ist, eine zweite Messspannung (229) an dem zweiten Messpunkt (227) in eine zweite digitale Messspannung zu wandeln.

12. Hausgerät-Mess-Vorrichtung (110) gemäß Anspruch 11, wobei die Hausgerät-Mess-Vorrichtung (110) einen Prozessor umfasst, der eingerichtet ist, auf Basis der ersten digitalen Messspannung und auf Basis der zweiten digitalen Messspannung als Messinformation einen Messwert für die Eingangsspannung (103), insbesondere einen Messwert für eine Amplitude der Eingangsspannung (103), zu ermitteln.

13. Hausgerät-Mess-Vorrichtung (110) gemäß Anspruch 12, wobei der Prozessor ausgebildet ist, den Messwert für die Eingangsspannung (103) näherungsweise zu berechnen, auf Basis von

$$U1\_U2 = \left( U\_M1\_GND * \frac{R\_1 * R\_M1 + R\_1 * R\_OS1 + R\_M1 * R\_OS1}{R\_M1 * R\_OS1} - VDD \right.$$
$$\left. * \frac{R\_1}{R\_OS1} \right)$$
$$- \left( U\_M2\_GND * \frac{R\_2 * R\_M2 + R\_2 * R\_OS2 + R\_M2 * R\_OS2}{R\_M2 * R\_OS2} - VDD \right.$$
$$\left. * \frac{R\_2}{R\_OS2} \right)$$

wobei

- U1_U2 der Messwert der Eingangsspannung (103) ist;
- U_M1_GND ein Wert der ersten digitalen Messspannung (219) ist;
- R_1 ein Wert des ersten Isolationswiderstands (212) ist;
- R_M1 ein Wert des ersten Mess-Widerstands (215) ist;
- R_OS1 ein Wert des ersten Offset-Widerstands (214) ist;
- VDD ein Wert der Betriebs-Spannung (201) relativ zu dem Referenzpotential (202) ist;
- U_M2_GND ein Wert der zweiten digitalen Messspannung (229) ist;
- R_2 ein Wert des zweiten Isolationswiderstands (222) ist;
- R_M2 ein Wert des zweiten Mess-Widerstands (225) ist; und
- R_OS2 ein Wert des zweiten Offset-Widerstands (224) ist.

14. Hausgerät (100), das umfasst,

- einen Netzanschluss (102) zur Anbindung des Hausgeräts (100) an eine AC-Versorgungsspannung (103);
- eine Hausgerät-Mess-Vorrichtung (110) gemäß einem der vorhergehenden Ansprüche, wobei die Hausgerät-Mess-Vorrichtung (110) eingerichtet ist, auf Basis der AC-Versorgungsspannung (103) Messinformation in Bezug auf die AC-Versorgungsspannung (103) zu ermitteln; und
- eine Steuereinheit (101), die eingerichtet ist, eine Funktion des Hausgeräts (100) in Abhängigkeit von der Messinformation zu betreiben.

**Claims**

1. Household appliance measurement apparatus (110) for determining measurement information relating to an input voltage (103) across an isolation barrier; wherein the household appliance measurement apparatus (110) comprises,

- a first input node (211) for coupling to a first pole of the input voltage (103);
- a first voltage divider (213), with a first offset resistor (214) and a first measurement resistor (215) which are arranged between an operating voltage (201) and a reference potential (202) of the household appliance measurement apparatus (110);
- a first isolation resistor (212) which connects the first input node (211) to a first measurement point (217) arranged between the first offset resistor (214) and the first measurement resistor (215) for measurement information relating to the input voltage (103);
- a second input node (221) for coupling to a second pole of the input voltage (103);
- a second voltage divider (223), with a second offset resistor (224) and a second measurement resistor (225), which are arranged between the operating voltage (201) and the reference potential (202) of the household appliance measurement apparatus (110); and
- a second isolation resistor (222) which connects the second input node (221) to a second measurement point (227) arranged between the second offset resistor (224) and the second measurement resistor (225) for measurement information relating to the input voltage (103),
- wherein the first isolation resistor (212) has a resistance value which is greater by a factor of 10 or more, or 100 or more or 1000 or more or 10000 or more than a resistance value of the first offset resistor (214) and/or of the first measurement resistor (215); and/or
- the second isolation resistor (222) has a resistance value which is greater by a factor of 10 or more, or 100 or more or 1000 or more or 10000 or more than a resistance value of the second offset resistor (224) and/or of the second measurement resistor (225).

2. Household appliance measurement apparatus (110) according to claim 1, wherein the first isolation resistor (212) and the second isolation resistor (222) have in each case a resistance value that is high enough such that a galvanic isolation with a leakage current is caused by way of the first isolation resistor (212) and by way of the second isolation resistor (222), which leakage current is smaller than a predefined leakage current threshold value.

3. Household appliance measurement apparatus (110) according to one of the preceding claims, wherein

- the input voltage (103) is part of a first voltage reference system (231), in particular an electricity supply network or an intermediate circuit of an electrical device (100); and/or
- the operating voltage (201) and/or the reference potential (202) is/are part of a second voltage reference system (232), in particular a Safety Extra Low Voltage, or SELV for short, or a Protective Extra Low Voltage, or PELV for short, voltage reference system.

4. Household appliance measurement apparatus (110) according to one of the preceding claims, wherein the household appliance measurement apparatus (110) is designed to determine measurement information relating to the input voltage (103) on the basis of a first measurement voltage (219) at the first measurement point (217), in particular a first measurement voltage (219) between the first measurement point (217) and the reference potential (202), and on the basis of a second measurement voltage (229) at the second measurement point (227), in particular a second measurement voltage (229) between the second measurement point (227) and the reference potential (202).

5. Household appliance measurement apparatus (110) according to one of the preceding claims, wherein

- the first measurement resistor (215) is arranged between the first measurement point (217) and the reference potential (202) of the household appliance measurement apparatus (110); and
- the first offset resistor (214) is arranged between the first measurement point (217) and the operating voltage (201) of the household appliance measurement apparatus (110); and/or
- the second measurement resistor (225) is arranged between the second measurement point (227) and the reference potential (202) of the household appliance measurement apparatus (110); and
- the second offset resistor (224) is arranged between the second measurement point (227) and the operating voltage (201) of the household appliance measurement apparatus (110).

6. Household appliance measurement apparatus (110) according to one of the preceding claims, wherein the household appliance measurement apparatus (110) is designed

- to provide a first measurement voltage (219) for the input voltage (103) at the first measurement resistor (215) and/or at the first measurement point (217), which has no change in polarity; and/or
- to provide a second measurement voltage (229) for the input voltage (103) at the second measurement resistor (225) and/or at the second measurement point (227), which has no change in polarity.

7. Household appliance measurement apparatus (110) according to claim 6, wherein

- the input voltage (103) has an amplitude of 100 V or more; and
- the first and/or the second measurement voltage (219, 229) have an amplitude of 50 V or less in each case.

8. Household appliance measurement apparatus (110) according to one of the preceding claims, wherein the household appliance measurement apparatus (110) comprises

- a first capacitor (216), which is arranged parallel to the first measurement resistor (215), in particular between the first measurement point (217) and the reference potential (202); and/or

- a second capacitor (216), which is arranged parallel to the second measurement resistor (225), in particular between the second measurement point (227) and the reference potential (202).

9. Household appliance measurement apparatus (110) according to one of the preceding claims, wherein

    - the household appliance measurement apparatus (110) comprises a comparator (240);
    - a first input of the comparator (240) is coupled to the first measurement point (217);
    - a second input of the comparator (240) is coupled to the second measurement point (227); and
    - the comparator (240) is designed to indicate, as an output signal (241), a change in polarity and/or a zero crossing of the input voltage (103).

10. Household appliance measurement apparatus (110) according to claim 10, wherein the household appliance measurement apparatus (110) comprises a processor which is configured to determine a frequency of the input voltage (103) on the basis of the output signal (241) of the comparator (240).

11. Household appliance measurement apparatus (110) according to one of the preceding claims, wherein the household appliance measurement apparatus (110) comprises

    - a first analogue-digital converter, which is configured to convert a first measurement voltage (219) at the first measurement point (217) into a first digital measurement voltage; and/or
    - a second analogue-digital converter, which is configured to convert a second measurement voltage (229) at the second measurement point (227) into a second digital measurement voltage.

12. Household appliance measurement apparatus (110) according to claim 11, wherein the household appliance measurement apparatus (110) comprises a processor, which is configured to determine, on the basis of the first digital measurement voltage and on the basis of the second digital measurement voltage, as measurement information, a measurement value for the input voltage (103), in particular a measurement value for an amplitude of the input voltage (103).

13. Household appliance measurement apparatus (110) according to claim 12, wherein the processor is designed to calculate the measurement value for the input voltage (103) approximately, on the basis of

$$U1\_U2 = \left( U\_M1\_GND * \frac{R\_1 * R\_M1 + R\_1 * R\_OS1 + R\_M1 * R\_OS1}{R\_M1 * R\_OS1} - VDD \right.$$
$$\left. * \frac{R\_1}{R\_OS1} \right)$$
$$- \left( U\_M2\_GND * \frac{R\_2 * R\_M2 + R\_2 * R\_OS2 + R\_M2 * R\_OS2}{R\_M2 * R\_OS2} - VDD \right.$$
$$\left. * \frac{R\_2}{R\_OS2} \right)$$

wherein

    - U1U2 is the measurement value of the input voltage (103);
    - U_M1_GND is a value of the first digital measurement voltage (219);
    - R_1 is a value of the first isolation resistor (212);
    - R_M1 is a value of the first measurement resistor (215);
    - R_OS1 is a value of the first offset resistor (214);
    - VDD is a value of the operating voltage (201) relative to the reference potential (202);
    - U_M2_GND is a value of the second digital measurement voltage (229);
    - R_2 is a value of the second isolation resistor (222);
    - R_M2 is a value of the second measurement resistor (225); and
    - R_OS2 is a value of the second offset resistor (224).

14. Household appliance (100), which comprises

- a network connection (102) for connecting the household appliance (100) to an AC supply voltage (103);
- a household appliance measurement apparatus (110) according to one of the preceding claims, wherein the household appliance measurement apparatus (110) is configured to determine measurement information relating to the AC supply voltage (103) on the basis of the AC supply voltage (103); and
- a control unit (101), which is configured to operate a function of the household appliance (100) as a function of the measurement information.

**Revendications**

1. Dispositif de mesure pour appareil ménager (110) destiné à déterminer des informations de mesure relatives à une tension d'entrée (103) à travers une barrière d'isolation, dans lequel le dispositif de mesure pour appareil ménager (100) comprend :

    - un premier nœud d'entrée (211) pour le couplage à un premier pôle de la tension d'entrée (103) ;
    - un premier diviseur de tension (213), avec une première résistance de décalage (214) et une première résistance de mesure (215), qui sont disposées entre une tension de service (201) et un potentiel de référence (202) du dispositif de mesure pour appareil ménager (110) ;
    - une première résistance d'isolement (212) qui relie le premier nœud d'entrée (211) à un premier point de mesure (217) disposé entre la première résistance de décalage (214) et la première résistance de mesure (215) pour obtenir des informations de mesure relatives à la tension d'entrée (103) ;
    - un deuxième nœud d'entrée (221) pour le couplage à un deuxième pôle de la tension d'entrée (103) ;
    - un deuxième diviseur de tension (223) avec une deuxième résistance de décalage (224) et une deuxième résistance de mesure (225), qui sont disposées entre la tension de service (201) et le potentiel de référence (202) du dispositif de mesure pour appareil ménager (110) ; et
    - une deuxième résistance d'isolement (222) qui relie le deuxième nœud d'entrée (221) à un deuxième point de mesure (227) disposé entre la deuxième résistance de décalage (224) et la deuxième résistance de mesure (225) pour obtenir des informations de mesure relatives à la tension d'entrée (103),
    - dans lequel la première résistance d'isolement (212) présente une valeur de résistance qui est supérieure d'un facteur 10 ou plus, ou 100 ou plus, ou 1 000 ou plus, ou 10 000 ou plus, à une valeur de résistance de la première résistance de décalage (214) et/ou de la première résistance de mesure (215) ; et/ou
    - la deuxième résistance d'isolement (222) présente une valeur de résistance qui est supérieure d'un facteur 10 ou plus, ou 100 ou plus, ou 1 000 ou plus, ou 10 000 ou plus, à une valeur de résistance de la deuxième résistance de décalage (224) et/ou de la deuxième résistance de mesure (225).

2. Dispositif de mesure pour appareil ménager (110) selon la revendication 1, dans lequel la première résistance d'isolement (212) et la deuxième résistance d'isolement (222) présentent chacune une valeur de résistance suffisamment élevée pour que la première résistance d'isolement (212) et la deuxième résistance d'isolement (222) assurent une isolation galvanique avec un courant de fuite qui est inférieur à une valeur seuil de courant de fuite prédéfinie.

3. Dispositif de mesure pour appareil ménager (110) selon l'une des revendications précédentes, dans lequel

    - la tension d'entrée (103) fait partie d'un premier système de référence de tension (231), en particulier d'un réseau d'alimentation électrique ou d'un circuit intermédiaire d'un appareil électrique (100) ; et/ou
    - la tension de service (201) et/ou le potentiel de référence (202) font partie d'un deuxième système de référence de tension (232), en particulier d'un système de référence à très basse tension de sécurité, en abrégé SELV, ou d'un système de référence à très basse tension de protection, en abrégé PELV.

4. Dispositif de mesure pour appareil ménager (110) selon l'une des revendications précédentes, dans lequel le dispositif de mesure pour appareil ménager (110) est conçu pour déterminer des informations de mesure relatives à la tension d'entrée (103) sur la base d'une première tension de mesure (219) au premier point de mesure (217), en particulier d'une première tension de mesure (219) entre le premier point de mesure (217) et le potentiel de référence (202), et sur la base d'une deuxième tension de mesure (229) au deuxième point de mesure (227), en particulier d'une deuxième tension de mesure (229) entre le deuxième point de mesure (227) et le potentiel de référence (202).

5. Dispositif de mesure pour appareil ménager (110) selon l'une des revendications précédentes, dans lequel

- la première résistance de mesure (215) est disposée entre le premier point de mesure (217) et le potentiel de référence (202) du dispositif de mesure pour appareil ménager (110) ; et
- la première résistance de décalage (214) est disposée entre le premier point de mesure (217) et la tension de service (201) du dispositif de mesure pour appareil ménager (110) ; et/ou
- la deuxième résistance de mesure (225) est disposée entre le deuxième point de mesure (227) et le potentiel de référence (202) du dispositif de mesure pour appareil ménager (110) ; et
- la deuxième résistance de décalage (224) est disposée entre le deuxième point de mesure (227) et la tension de service (201) du dispositif de mesure pour appareil ménager (110).

6. Dispositif de mesure pour appareil ménager (110) selon l'une des revendications précédentes, dans lequel le dispositif de mesure pour appareil ménager est conçu pour

- fournir, au niveau de la première résistance de mesure (215) et/ou au niveau du premier point de mesure (217), une première tension de mesure (219) pour la tension d'entrée (103), qui ne présente aucun changement de polarité ; et/ou
- fournir, au niveau de la deuxième résistance de mesure (225) et/ou au niveau du deuxième point de mesure (227), une deuxième tension de mesure (229) pour la tension d'entrée (103), qui ne présente aucun changement de polarité.

7. Dispositif de mesure pour appareil ménager (110) selon la revendication 6, dans lequel

- la tension d'entrée (103) présente une amplitude de 100 V ou plus ; et
- la première et/ou la deuxième tension de mesure (219, 229) présentent chacune une amplitude de 50 V ou moins.

8. Dispositif de mesure pour appareil ménager (110) selon l'une des revendications précédentes, dans lequel le dispositif de mesure pour appareil ménager comprend

- un premier condensateur (216) qui est disposé en parallèle avec la première résistance de mesure (215), en particulier entre le premier point de mesure (217) et le potentiel de référence (202) ; et/ou
- un deuxième condensateur (226) qui est disposé en parallèle avec la deuxième résistance de mesure (225), en particulier entre le deuxième point de mesure (227) et le potentiel de référence (202).

9. Dispositif de mesure pour appareil ménager (110) selon l'une des revendications précédentes, dans lequel

- le dispositif de mesure pour appareil ménager (110) comprend un comparateur (240) ;
- une première entrée du comparateur (240) est couplée au premier point de mesure (217) ;
- une deuxième entrée du comparateur (240) est couplée au deuxième point de mesure (227) ; et
- le comparateur (240) est conçu pour indiquer, en tant que signal de sortie (241), un changement de polarité et/ou un retour au niveau zéro de la tension d'entrée (103).

10. Dispositif de mesure pour appareil ménager (110) selon la revendication 10, dans lequel le dispositif de mesure pour appareil ménager (110) comprend un processeur qui est configuré pour déterminer une fréquence de la tension d'entrée (103) sur la base du signal de sortie (241) du comparateur (240).

11. Dispositif de mesure pour appareil ménager (110) selon l'une des revendications précédentes, dans lequel le dispositif de mesure pour appareil ménager (110) comprend

- un premier convertisseur analogique-numérique qui est conçu pour convertir une première tension de mesure (219) au premier point de mesure (217) en une première tension de mesure numérique ; et/ou
- un deuxième convertisseur analogique-numérique qui est conçu pour convertir une deuxième tension de mesure (229) au deuxième point de mesure (227) en une deuxième tension de mesure numérique.

12. Dispositif de mesure pour appareil ménager (110) selon la revendication 11, dans lequel le dispositif de mesure pour appareil ménager (110) comprend un processeur qui est configuré pour déterminer en tant qu'information de mesure, sur la base de la première tension de mesure numérique et sur la base de la deuxième tension de mesure numérique, une valeur de mesure pour la tension d'entrée (103), en particulier une valeur de mesure pour une amplitude de la tension d'entrée (103).

**13.** Dispositif de mesure pour appareil ménager (110) selon la revendication 12, dans lequel le processeur est conçu pour calculer approximativement la valeur de mesure pour la tension d'entrée (103) sur la base de

$$U1\_U2 = \left( U\_M1\_GND * \frac{R\_1 * R\_M1 + R\_1 * R\_OS1 + R\_M1 * R\_OS1}{R\_M1 * R\_OS1} - VDD \right.$$
$$\left. * \frac{R\_1}{R\_OS1} \right)$$
$$- \left( U\_M2\_GND * \frac{R\_2 * R\_M2 + R\_2 * R\_OS2 + R\_M2 * R\_OS2}{R\_M2 * R\_OS2} - VDD \right.$$
$$\left. * \frac{R\_2}{R\_OS2} \right)$$

dans lequel

- U1_U2 est la valeur de mesure de la tension d'entrée (103) ;
- U_M1_GND est une valeur de la première tension de mesure numérique (219) ;
- R_1 est une valeur de la première résistance d'isolement (212) ;
- R_M1 est une valeur de la première résistance de mesure (215) ;
- R_OS1 est une valeur de la première résistance de décalage (214) ;
- VDD est une valeur de la tension de service (201) par rapport au potentiel de référence (202) ;
- U_M2_GND est une valeur de la deuxième tension de mesure numérique (229) ;
- R_2 est une valeur de la deuxième résistance d'isolement (222) ;
- R_M2 est une valeur de la deuxième résistance de mesure (225) ; et
- R_OS2 est une valeur de la deuxième résistance de décalage (224).

**14.** Appareil ménager (100) comprenant

- une connexion réseau (102) pour le raccordement de l'appareil ménager (100) à une tension d'alimentation CA (103) ;
- un dispositif de mesure pour appareil ménager (110) selon l'une des revendications précédentes, dans lequel le dispositif de mesure pour appareil ménager (110) est conçu pour déterminer, sur la base de la tension d'alimentation CA (103), des informations de mesure relatives à la tension d'alimentation CA (103) ; et
- une unité de commande (101) qui est configurée pour activer une fonction de l'appareil ménager (100) en fonction des informations de mesure.

**Fig. 1**

**Fig. 2a**

Fig. 2b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2011064559 A
- WO 2006085771 A1
- US 2018279413 A1
- US 2003168995 A1
- JP 2015023608 A
- JP 2012002542 A
- CN 105870931 B
- DE 102017205359 A1